# EUROPEAN PATENT APPLICATION

(11) **EP 4 557 377 A1**
(43) Date of publication of application: **21.05.2025**
(21) Application number: 23841874.3
(22) Date of filing: 16.05.2023
(51) Int. Cl.: H01L 31/02

(54) **PHOTOVOLTAIC SHINGLED ASSEMBLY AND PREPARATION METHOD THEREFOR**

(30) Priority: 21.07.2022 CN 202210858297
(71) Applicant: Changzhou Shichuang Energy Co., Ltd, Changzhou, Jiangsu 213300 (CN)
(72) Inventor: MENG, Xiangmin, Xuzhou, Jiangsu 221300 (CN); CHEN, Zhangyang, Pingxiang, Jiangxi 337000 (CN); CAO, Yuhong, Nanjing, Jiangsu 211100 (CN); FU, Liming, Hangzhou, Zhejiang 310000 (CN)
(74) Representative: Miller, Ronald Anthony
(86) International application number: PCT/CN2023/094404
(87) International publication number: WO 2024/016805

(57) **Abstract**

Disclosed is a photovoltaic shingled module, including a cell string formed by cell sheets connected in a shingled manner. Metal wires are provided on a front surface and a back surface of each of the cell sheets and respectively cover seed layer fingers. Two adjacent cell sheets of the cell sheets in the cell string are connected through a sheet conductive connection material. In the present disclosure, the sheet conductive connection material is used to replace an electrically conductive adhesive, and the position of the sheet conductive connection material can be flexibly arranged according to different layout modes, so that the sheet conductive connection material forms a stable electrical connection with two adjacent cell sheets, thereby reducing the costs and improving the efficiency. The present disclosure can improve the strength and reliability of the connection between cell sheets in a shingled module, reduce the material costs, and improve the power of the shingled module. According to the present disclosure, the current transmission path in the module is optimized, and transverse transmission of the current through fingers is eliminated, so that the fingers only provide a function of connecting cells and metal wires, which substantially has no requirements on the diameter of the fingers. Therefore, the metal consumption of the fingers can be reduced by a maximum of 80% or more, thereby greatly reducing the material costs.

## Description

### TECHNICAL FIELD

The present disclosure relates to a photovoltaic shingled module and a manufacturing method therefor.

### BACKGROUND

A shingled module is generally a module obtained by cutting a conventional cell sheet into small pieces and then interconnecting the small pieces in series through an electrically conductive adhesive, followed by lamination and encapsulating. Such an interconnection method replaces conventional methods that use metal grid lines for interconnection in a module, avoids the step of screen printing busbars of a cell, and reduces line loss and shading of light by the grid lines. Moreover, because the shingled module does not have a gap between cell sheets, the power of the shingled module is higher than that of conventional modules with the same area.

However, at present, shingled modules face two major problems. 1. Low cell-to-module (CTM) ratio. This is mainly because the current is transmitted through fingers in the shingled module, and the current transmission path is increased by at least 400% compared with existing 16-busbar (16BB) cells. This leads to a high line loss of the shingled cell and therefore a higher power loss of the module. In addition, in a conventional module, a diffuse reflection structure (such as a backsheet) is generally provided between cell sheets to increase the secondary absorption of light by the cell sheets. In contrast, in the shingled module, two adjacent cell sheets are interconnected by overlapping them vertically for current transmission, and there is no inter-cell gain. 2. High costs: 1) In the shingled module, cell sheets are interconnected through an electrically conductive adhesive, and the main component of the electrically conductive adhesive is silver particles, and the cost of silver is high. Because the electrically conductive adhesive transmits the current through the contact between conductive particles, a decrease in solid content indicates a reduction in conductivity, resulting in very high silver consumption. Moreover, the electrically conductive adhesive needs to be stored at -20°C or below, leading to high storage costs. In addition, the electrically conductive adhesive requires high equipment precision and a complicated application method. Therefore, for shingled modules, the material cost of the electrically conductive adhesive and the cost of applying the electrically conductive adhesive are already very high. 2) The transmission path through the fingers in the shingled module is long. To reduce the power loss caused by line loss, the finger width needs to be increased, leading to an increase in silver consumption. 3) The overlapping area between cell sheets in the shingled module is generally 0.5 mm to 1 mm, and the overlapping area leads to a waste of the silicon material.

To solve the problems of high costs and low CTM ratio of shingled modules, some manufacturers adopt a method of soldering metal ribbons on the cell surface to serve as busbars to collect and transmit the current, so as to shorten the current transmission path through the fingers, reduce line loss, and improve the power of the shingled module. However, the reduction in material and equipment costs from the use of the electrically conductive adhesive is very small.

In addition, the metal in fingers of photovoltaic cell sheets is generally silver. In a conventional shingled module, a current is collected from a surface of a cell sheet to silver fingers, and is directly transmitted to an adjacent cell sheet through the silver fingers. Because the cross-sectional area of the silver fingers is small, a conventional shingled cell sheet has to be cut into narrow strips multiple times to reduce the current transmission distance in the silver fingers, thereby reducing the loss due to electrical resistance.

### SUMMARY

To solve the disadvantages of the prior art, the present disclosure provides a photovoltaic shingled module, which includes a cell string formed by cell sheets connected in a shingled manner. Metal wires are provided on a front surface and a back surface of each of the cell sheets and respectively cover seed layer fingers (which may be silver fingers). Two adjacent cell sheets of the cell sheets in the cell string are connected through a sheet conductive connection material. The sheet conductive connection material is an electrically conductive adhesive tape (double-sided electrically conductive adhesive tape), an ultra-thin alloy material, or an ultra-thin metal sheet coated with a solder material on a surface thereof.

Preferably, the seed layer fingers and the metal wires are arranged in parallel on the front surface and the back surface of each of the cell sheets, and a pitch between two adjacent seed layer fingers of the seed layer fingers and a pitch between two adjacent metal wires of the metal wires each range from 1 mm to 3 mm.

Preferably, a plurality of front metal wires are provided on the front surface of each of the cell sheets and respectively cover the seed layer fingers and are arranged in parallel, and the plurality of front metal wires extend in a head-to-tail direction of a respective cell sheet of the cell sheets on which the plurality of front metal wires are located. Tail ends of the plurality of front metal wires extend to an outer side of a tail end of the respective cell sheet on which the plurality of front metal wires are located, and the sheet conductive connection material is located at the tail ends of the plurality of front metal wires. A length of the tail ends of the plurality of front metal wires extending out of the outer side of the tail end of the respective cell sheet is not greater than 5 mm, preferably not greater than 2 mm.

Preferably, the ultra-thin alloy material can be melted and solidified again during module lamination, and the solder material on the surface of the ultra-thin metal sheet can be melted and solidified again during the module lamination.

The present disclosure also provides several methods for manufacturing a photovoltaic shingled module. For steps of the methods, see examples in the detailed description section.

### Advantages

The present disclosure has the following advantages.

In the photovoltaic shingled module of the present disclosure, the current transmission path is that a current is transmitted from a substrate of a cell sheet to the surface of the cell sheet, then vertically transmitted to the metal wires through the seed layer fingers on the surface of the cell sheet, then transmitted to the sheet conductive connection material through the metal wires, and transmitted to an adjacent cell sheet through the sheet conductive connection material. The seed layer fingers only provide a function of vertically conducting the current and transmitting the current to the metal wires, and do not have a function of transversely transmitting the current.

As mentioned above, a metal in fingers of photovoltaic cell sheets is generally silver. According to the present disclosure, the current transmission path in the module is optimized, and transverse transmission of the current through the fingers is eliminated, so that the fingers only provide a function of connecting cells and metal wires, which substantially has no requirements on the diameter of the fingers. Therefore, the metal consumption of the fingers can be reduced by a maximum of 80% or more, thereby greatly reducing the material costs.

As mentioned above, in a conventional shingled module, a current is collected from a surface of a cell sheet to silver fingers, and is directly transmitted to an adjacent cell sheet through the silver fingers. Because the cross-sectional area of the silver fingers is small, a conventional shingled cell sheet has to be cut into narrow strips multiple times to reduce the current transmission distance in the silver fingers, thereby reducing the loss due to electrical resistance. In the present disclosure, the current is directly transmitted through the metal wires, which have a large cross-sectional area, small electrical resistance, and low loss. Therefore, a wider cell sheet can be used to prepare a shingled module, so that the number of times of cell sheet cutting and the efficiency loss caused by the cell sheet cutting can be reduced, thereby improving the manufacturing speed of the module. In addition, the metal wires can be shaped to reduce the shading of light by the metal wires on the surface of the cell sheet, to further improve the efficiency of the module. The shape of the metal wires is preferably triangular, circular, semicircular, etc.

In the present disclosure, the sheet conductive connection material, such as an electrically conductive adhesive tape (double-sided electrically conductive adhesive tape), an ultra-thin alloy material, or an ultra-thin metal sheet coated with a solder material on a surface thereof, is used to replace an electrically conductive adhesive, and the position of the sheet conductive connection material can be flexibly arranged according to different layout modes, so that the sheet conductive connection material forms a stable electrical connection with two adjacent cell sheets, thereby reducing the costs and improving the efficiency.

The present disclosure can improve the strength and reliability of the connection between cell sheets in a shingled module, reduce the material costs, and improve the power of the shingled module.

In the present disclosure, the tail ends of the plurality of front metal wires extend out of the outer side of the tail end of the respective cell sheet, the sheet conductive connection material is located at the tail ends of the plurality of front metal wires, and a back surface of a head end of a cell sheet of the cell sheets is fixedly connected to the tail ends of the plurality of front metal wires of a previous adjacent cell sheet of the cell sheets through the sheet conductive connection material. This can avoid or reduce the shading of the tail end of the previous adjacent cell sheet by the head end of the cell sheet and the shading of the front surface of each of the cell sheets by the sheet conductive connection material. As such, the waste of silicon material due to overlapping of the cell sheets can be reduced to reduce the costs. The inter-cell gain can be increased to improve the CTM ratio of the shingled module. The shading of light can be reduced to improve the efficiency of the module.

According to the present disclosure, a lead-out length of the plurality of front metal wires (i.e., the length of the tail ends of the plurality of front metal wires extending out of the outer side of the tail end of the respective cell sheet) can be designed according to the thickness of the cell sheet, the module layout mode, etc. A yield strength of each of the plurality of front metal wires is not greater than 120 MPa, so that the plurality of front metal wires with a small lead-out length (i.e., the length of the tail ends of the plurality of front metal wires extending out of the outer side of the tail end of the respective cell sheet is not greater than 5 mm, preferably not greater than 2 mm) will not fracture the cell sheet, and the stress in the cell sheet after soldering and the risk of cell fracturing after long-term use can be reduced.

In the present disclosure, a base material of the sheet conductive connection material is a metal or alloy material with relatively soft texture. In the present disclosure, a yield strength of the sheet conductive connection material does not exceed 120 MPa to ensure that the sheet conductive connection material, when arranged on the back surface of the cell sheet, will not cause the risks of cell fracturing during lamination and reliability deterioration after long-term use.

In the present disclosure, soldering of the sheet conductive connection material may be implemented during lamination in a module manufacturing process (where the ultra-thin alloy material can be melted and solidified again during module lamination, and the solder material on the surface of the ultra-thin metal sheet can be melted and solidified again during module lamination). Therefore, different from conventional shingled modules, the present disclosure does not require butt soldering of the electrically conductive adhesive. According to the present disclosure, the electrical connection may be implemented directly in the laminating machine after the module stack is completed. As such, the process steps are simplified. Such a method is also in line with the principle of shingled modules using surface soldering to replace spot-line soldering of conventional modules, and soldering with a metal alloy achieves improved soldering reliability and reduced material costs compared to an electrically conductive adhesive.

### EMBODIMENTS OF THE PRESENT DISCLOSURE

### DETAILED DESCRIPTION OF THE EMBODIMENTS

The specific embodiments of the present disclosure will be described in further detail with reference to examples. The following embodiments are merely used for more clearly describing the technical solutions of the present disclosure, and are not intended to limit the protection scope of the present disclosure.

The following technical solutions are employed in the embodiments of the present disclosure.

### Example 1

The present disclosure provides a photovoltaic shingled module, which is prepared by the following steps.
1) A photovoltaic frontsheet (e.g., photovoltaic glass) and a front encapsulant film are laid.
2) Rectangular cell sheets are laid on the front encapsulant film, and the cell sheets are stacked in a head-to-tail configuration to form one or more cell strings. A head-to-tail direction of each of the cell sheets is a lengthwise direction of each of the cell sheets. During the stacking, a back surface of a head end of a cell sheet of the cell sheets is stacked on a front surface of a tail end of a previous adjacent cell sheet of the cell sheets. A sheet conductive connection material for a shingle interconnection is provided in advance on a front surface of a tail end and/or a back surface of a head end of each of the cell sheets. The sheet conductive connection material is an elongated sheet conductive connection material with a lengthwise direction perpendicular to the head-to-tail direction of the cell sheet. The sheet conductive connection material is an electrically conductive adhesive tape (double-sided electrically conductive adhesive tape), an ultra-thin alloy material, or an ultra-thin metal sheet coated with a solder material on a surface thereof. The sheet conductive connection material is soldered, so that two adjacent cell sheets in a cell string of the one or more cell strings are fixedly connected together through the sheet conductive connection material (the back surface of the head end of a cell sheet of the cell sheets is fixedly connected to the front surface of the tail end of a previous adjacent cell sheet of the cell sheets through the sheet conductive connection material).
3) A bus wire and electrode lead wires are soldered.
4) A back encapsulant film and a photovoltaic backsheet (which may be back glass) are laid to form a stack to be laminated.
5) The stack is laminated in a laminating machine to bond the stack into a unity.
6) A junction box and a module frame are installed.

Metal wires respectively covering seed layer fingers may be further provided on the front surface and/or the back surface of each of the cell sheets used in step 2) of Example 1. More specifically,
a plurality of front metal wires respectively covering the seed layer fingers and arranged in parallel may be further provided on the front surface of each of the cell sheets used in step 2) (where front seed layer fingers are respectively provided for the plurality of front metal wires). The plurality of front metal wires extend in the head-to-tail direction of a respective cell sheet of the cell sheets on which the plurality of front metal wires are located. Tail ends of the plurality of front metal wires are connected to the sheet conductive connection material. A pitch between two adjacent front metal wires of the plurality of front metal wires ranges from 1 mm to 3 mm. A cross-section of each of the plurality of front metal wires is triangular, circular, semicircular, etc.

A plurality of back metal wires respectively covering the seed layer fingers and arranged in parallel may be further provided on the back surface of each of the cell sheets used in step 2) (where back seed layer fingers are respectively provided for the plurality of back metal wires). The plurality of back metal wires extend in the head-to-tail direction of a respective cell sheet of the cell sheets on which the plurality of back metal wires are located. Head ends of the plurality of back metal wires are connected to the sheet conductive connection material. A pitch between two adjacent back metal wires of the plurality of back metal wires ranges from 1 mm to 3 mm. The plurality of front metal wires and the plurality of back metal wires each have a triangular cross-section, a circular cross-section, a semicircular cross-section, or the like.

### Example 2

The present disclosure also provides another photovoltaic shingled module, which is prepared by the following steps.
1) A photovoltaic frontsheet (e.g., photovoltaic glass) and a front encapsulant film are laid.
2) Rectangular cell sheets are laid on the front encapsulant film, and the cell sheets are stacked in a head-to-tail configuration to form one or more cell strings. A head-to-tail direction of each of the cell sheets is a lengthwise direction of each of the cell sheets. During the stacking, a back surface of a head end of a cell sheet of the cell sheets is stacked on a front surface of a tail end of a previous adjacent cell sheet of the cell sheets. A sheet conductive connection material for a shingle interconnection is provided in advance on a front surface of a tail end and/or a back surface of a head end of each of the cell sheets. The sheet conductive connection material is an elongated sheet conductive connection material with a lengthwise direction perpendicular to the head-to-tail direction of the cell sheet. The sheet conductive connection material is an ultra-thin alloy material, or an ultra-thin metal sheet coated with a solder material on a surface thereof. The ultra-thin alloy material can be melted and solidified again during module lamination, and the solder material on the surface of the ultra-thin metal sheet can be melted and solidified again during module lamination.
3) A bus wire and electrode lead wires are soldered.
4) A back encapsulant film and a photovoltaic backsheet (which may be back glass) are laid to form a stack to be laminated.
5) The stack is laminated in a laminating machine to bond the stack into a unity. The lamination is performed at a temperature ranging from 130°C to 160°C. During the lamination, the ultra-thin alloy material or the solder material on the surface of the ultra-thin metal sheet is melted to fixedly connect two adjacent cell sheets of the cell sheets together (the back surface of the head end of a cell sheet of the cell sheets is fixedly connected to the front surface of the tail end of a previous adjacent cell sheet of the cell sheets through the sheet conductive connection material).
6) A junction box and a module frame are installed.

Metal wires respectively covering seed layer fingers may be further provided on the front surface and/or the back surface of each of the cell sheets used in step 2) of Example 2. More specifically,
a plurality of front metal wires respectively covering the seed layer fingers and arranged in parallel may be further provided on the front surface of each of the cell sheets used in step 2) (where front seed layer fingers are respectively provided for the plurality of front metal wires). The plurality of front metal wires extend in the head-to-tail direction of a respective cell sheet of the cell sheets on which the plurality of front metal wires are located. Tail ends of the plurality of front metal wires are connected to the sheet conductive connection material. A pitch between two adjacent front metal wires of the plurality of front metal wires ranges from 1 mm to 3 mm. A cross-section of each of the plurality of front metal wires is triangular, circular, semicircular, etc.

A plurality of back metal wires respectively covering the seed layer fingers and arranged in parallel may be further provided on the back surface of each of the cell sheets used in step 2) (where back seed layer fingers are respectively provided for the plurality of back metal wires). The plurality of back metal wires extend in the head-to-tail direction of a respective cell sheet of the cell sheets on which the plurality of back metal wires are located. Head ends of the plurality of back metal wires are connected to the sheet conductive connection material. A pitch between two adjacent back metal wires of the plurality of back metal wires ranges from 1 mm to 3 mm. A cross-section of each of the plurality of back metal wires is triangular, circular, semicircular, etc.

### Example 3

The present disclosure also provides another photovoltaic shingled module, which is prepared by the following steps.
1) A photovoltaic frontsheet (e.g., photovoltaic glass) and a front encapsulant film are laid.
2) Rectangular cell sheets each having a plurality of front metal wires are laid on the front encapsulant film, and the cell sheets are stacked in a head-to-tail configuration to form one or more cell strings. A head-to-tail direction of each of the cell sheets is a lengthwise direction of each of the cell sheets. During the stacking, a back surface of a head end of a cell sheet of the cell sheets is stacked on tail ends of the plurality of front metal wires of a previous adjacent cell sheet of the cell sheets. The plurality of front metal wires are provided on a front surface of each of the cell sheets and respectively cover seed layer fingers and are arranged in parallel (where front seed layer fingers are respectively provided for the plurality of front metal wires). The plurality of front metal wires extend in the head-to-tail direction of a respective cell sheet of the cell sheets on which the plurality of front metal wires are located. A pitch between two adjacent front metal wires of the plurality of front metal wires ranges from 1 mm to 3 mm. A cross-section of each of the plurality of front metal wires is triangular, circular, semicircular, etc. Tail ends of the plurality of front metal wires extend to an outer side of a tail end of the respective cell sheet on which the plurality of front metal wires are located. A length of the tail ends of the plurality of front metal wires extending out of the outer side of the tail end of the respective cell sheet on which the plurality of front metal wires are located is not greater than 5 mm (preferably not greater than 2 mm). A sheet conductive connection material for a shingle interconnection is provided in advance on the tail ends of the plurality of front metal wires of each of the cell sheets and/or on a back surface of a head end of each of the cell sheets. The sheet conductive connection material is an elongated sheet conductive connection material with a lengthwise direction perpendicular to the head-to-tail direction of a respective one of the cell sheets. The sheet conductive connection material is an electrically conductive adhesive tape (double-sided electrically conductive adhesive tape), an ultra-thin alloy material, or an ultra-thin metal sheet coated with a solder material on a surface thereof. The sheet conductive connection material is soldered, so that two adjacent cell sheets in a cell string of the one or more cell strings are fixedly connected together through the sheet conductive connection material (the back surface of the head end of a cell sheet of the cell sheets is fixedly connected to the tail ends of the plurality of front metal wires of a previous adjacent cell sheet of the cell sheets through the sheet conductive connection material).
3) A bus wire and electrode lead wires are soldered.
4) A back encapsulant film and a photovoltaic backsheet (which may be back glass) are laid to form a stack to be laminated.
5) The stack is laminated in a laminating machine to bond the stack into a unity.
6) A junction box and a module frame are installed.

Metal wires respectively covering seed layer fingers may be further provided on the back surface of each of the cell sheets used in step 2) of Example 3. More specifically,
a plurality of back metal wires respectively covering the seed layer fingers and arranged in parallel may be further provided on the back surface of each of the cell sheets used in step 2) (where back seed layer fingers are respectively provided for the plurality of back metal wires). The plurality of back metal wires extend in the head-to-tail direction of a respective cell sheet of the cell sheets on which the plurality of back metal wires are located. Head ends of the plurality of back metal wires are connected to the sheet conductive connection material. A pitch between two adjacent back metal wires of the plurality of back metal wires ranges from 1 mm to 3 mm. A cross-section of each of the plurality of back metal wires is triangular, circular, semicircular, etc.

### Example 4

The present disclosure also provides another photovoltaic shingled module, which is prepared by the following steps.
1) A photovoltaic frontsheet (e.g., photovoltaic glass) and a front encapsulant film are laid.
2) Rectangular cell sheets each having a plurality of front metal wires are laid on the front encapsulant film, and the cell sheets are stacked in a head-to-tail configuration to form one or more cell strings. A head-to-tail direction of each of the cell sheets is a lengthwise direction of each of the cell sheets. During the stacking, a back surface of a head end of a cell sheet of the cell sheets is stacked on tail ends of the plurality of front metal wires of a previous adjacent cell sheet of the cell sheets. The plurality of front metal wires are provided on a front surface of each of the cell sheets and respectively cover seed layer fingers and are arranged in parallel (where front seed layer fingers are respectively provided for the plurality of front metal wires). The plurality of front metal wires extend in the head-to-tail direction of a respective cell sheet of the cell sheets on which the plurality of front metal wires are located. A pitch between two adjacent front metal wires of the plurality of front metal wires ranges from 1 mm to 3 mm. A cross-section of each of the plurality of front metal wires is triangular, circular, semicircular, etc. Tail ends of the plurality of front metal wires extend to an outer side of a tail end of the respective cell sheet on which the plurality of front metal wires are located. A length of the tail ends of the plurality of front metal wires extending out of the outer side of the tail end of the respective cell sheet on which the plurality of front metal wires are located is not greater than 5 mm (preferably not greater than 2 mm). A sheet conductive connection material for a shingle interconnection is provided in advance on the tail ends of the plurality of front metal wires of each of the cell sheets and/or on a back surface of a head end of each of the cell sheets. The sheet conductive connection material is an elongated sheet conductive connection material with a lengthwise direction perpendicular to the head-to-tail direction of a respective one of the cell sheets. The sheet conductive connection material is an ultra-thin alloy material, or an ultra-thin metal sheet coated with a solder material on a surface thereof. The ultra-thin alloy material can be melted and solidified again during module lamination, and the solder material on the surface of the ultra-thin metal sheet can be melted and solidified again during module lamination.
3) A bus wire and electrode lead wires are soldered.
4) A back encapsulant film and a photovoltaic backsheet (which may be back glass) are laid to form a stack to be laminated.
5) The stack is laminated in a laminating machine to bond the stack into a unity. The lamination is performed at a temperature ranging from 130°C to 160°C. During the lamination, the ultra-thin alloy material or the solder material on the surface of the ultra-thin metal sheet is melted to fixedly connect two adjacent cell sheets of the cell sheets together (the back surface of the head end of a cell sheet of the cell sheets is fixedly connected to the tail ends of the plurality of front metal wires of a previous adjacent cell sheet of the cell sheets through the sheet conductive connection material).
6) A junction box and a module frame are installed.

Metal wires respectively covering seed layer fingers may be further provided on the back surface of each of the cell sheets used in step 2) of Example 4. More specifically,
a plurality of back metal wires respectively covering the seed layer fingers and arranged in parallel may be further provided on the back surface of each of the cell sheets used in step 2) (where back seed layer fingers are respectively provided for the plurality of back metal wires). The plurality of back metal wires extend in the head-to-tail direction of a respective cell sheet of the cell sheets on which the plurality of back metal wires are located. Head ends of the plurality of back metal wires are connected to the sheet conductive connection material. A pitch between two adjacent back metal wires of the plurality of back metal wires ranges from 1 mm to 3 mm. A cross-section of each of the plurality of back metal wires is triangular, circular, semicircular, etc.

Specifically, in Example 1 to Example 4,
a yield strength of each of the plurality of front metal wires is not greater than 120 MPa.

A thickness of the sheet conductive connection material is not greater than 0.1 mm.

A yield strength of the sheet conductive connection material is not greater than 120 MPa.

While preferred embodiments of the present disclosure have been described above, the present disclosure is not limited thereto. It should be appreciated that some improvements and modifications can be made by those skilled in the art without departing from the technical principles of the present disclosure, which are also contemplated to be within the scope of the present disclosure.

## Claims

1. A photovoltaic shingled module, comprising a cell string formed by cell sheets connected in a shingled manner, **characterized in that** metal wires are provided on a front surface and a back surface of each of the cell sheets and respectively cover seed layer fingers; two adjacent cell sheets of the cell sheets in the cell string are connected through a sheet conductive connection material; and the sheet conductive connection material is an electrically conductive adhesive tape, an ultra-thin alloy material, or an ultra-thin metal sheet coated with a solder material on a surface thereof.

2. The photovoltaic shingled module according to claim 1, **characterized in that** a plurality of front metal wires are provided on the front surface of each of the cell sheets and respectively cover the seed layer fingers and are arranged in parallel, the plurality of front metal wires extend in a head-to-tail direction of a respective cell sheet of the cell sheets, and tail ends of the plurality of front metal wires are connected to the sheet conductive connection material.

3. The photovoltaic shingled module according to claim 2, **characterized in that** a plurality of back metal wires are provided on the back surface of each of the cell sheets and respectively cover the seed layer fingers and are arranged in parallel, the plurality of back metal wires extend in a head-to-tail direction of a respective cell sheet of the cell sheets, and head ends of the plurality of back metal wires are connected to the sheet conductive connection material.

4. The photovoltaic shingled module according to claim 3, **characterized in that** a pitch between two adjacent front metal wires of the plurality of front metal wires ranges from 1 mm to 3 mm, and a pitch between two adjacent back metal wires of the plurality of back metal wires ranges from 1 mm to 3 mm.

5. The photovoltaic shingled module according to claim 3, **characterized in that** the plurality of front metal wires and the plurality of back metal wires each have a triangular cross-section, a circular cross-section, or a semicircular cross-section.

6. The photovoltaic shingled module according to claim 2 or 3, **characterized in that** the tail ends of the plurality of front metal wires extend to an outer side of a tail end of the respective cell sheet, and the sheet conductive connection material is located at the tail ends of the plurality of front metal wires.

7. The photovoltaic shingled module according to claim 6, **characterized in that** a length of the tail ends of the plurality of front metal wires extending out of the outer side of the tail end of the respective cell sheet is not greater than 5 mm.

8. The photovoltaic shingled module according to claim 6, **characterized in that** a yield strength of each of the plurality of front metal wires is not greater than 120 MPa.

9. The photovoltaic shingled module according to claim 1, **characterized in that** a thickness of the sheet conductive connection material is not greater than 0.1 mm.

10. The photovoltaic shingled module according to claim 1, **characterized in that** a yield strength of the sheet conductive connection material is not greater than 120 MPa.

11. The photovoltaic shingled module according to claim 1, **characterized in that** the sheet conductive connection material is an elongated sheet conductive connection material, and a lengthwise direction of the elongated sheet conductive connection material is perpendicular to a head-to-tail direction of a respective one of the cell sheets.

12. A method for manufacturing a photovoltaic shingled module, **characterized by** comprising the following steps:
1) laying a photovoltaic frontsheet and a front encapsulant film;
2) laying cell sheets on the front encapsulant film, and stacking the cell sheets in a head-to-tail configuration to form one or more cell strings, wherein during the stacking, a back surface of a head end of a cell sheet of the cell sheets is stacked on a front surface of a tail end of a previous adjacent cell sheet of the cell sheets, a sheet conductive connection material for a shingle interconnection is provided in advance on a front surface of a tail end and/or a back surface of a head end of each of the cell sheets, and the sheet conductive connection material is an electrically conductive adhesive tape, an ultra-thin alloy material, or an ultra-thin metal sheet coated with a solder material on a surface thereof; and soldering the sheet conductive connection material, so that two adjacent cell sheets in a cell string of the one or more cell strings are fixedly connected together through the sheet conductive connection material;
3) soldering a bus wire and electrode lead wires;
4) laying a back encapsulant film and a photovoltaic backsheet to form a stack to be laminated;
5) laminating the stack in a laminating machine to bond the stack into a unity; and
6) installing a junction box and a module frame.

13. A method for manufacturing a photovoltaic shingled module, **characterized by** comprising the following steps:
1) laying a photovoltaic frontsheet and a front encapsulant film;
2) laying cell sheets on the front encapsulant film, and stacking the cell sheets in a head-to-tail configuration to form one or more cell strings, wherein during the stacking, a back surface of a head end of a cell sheet of the cell sheets is stacked on a front surface of a tail end of a previous adjacent cell sheet of the cell sheets, a sheet conductive connection material for a shingle interconnection is provided in advance on a front surface of a tail end and/or a back surface of a head end of each of the cell sheets, and the sheet conductive connection material is an ultra-thin alloy material or an ultra-thin metal sheet coated with a solder material on a surface thereof;
3) soldering a bus wire and electrode lead wires;
4) laying a back encapsulant film and a photovoltaic backsheet to form a stack to be laminated;
5) laminating the stack in a laminating machine to bond the stack into a unity, wherein during the laminating, the ultra-thin alloy material or the solder material on the surface of the ultra-thin metal sheet is melted to fixedly connect two adjacent cell sheets of the cell sheets together; and
6) installing a junction box and a module frame.

14. A method for manufacturing a photovoltaic shingled module, **characterized by** comprising the following steps:
1) laying a photovoltaic frontsheet and a front encapsulant film;
2) laying cell sheets each having a plurality of front metal wires on the front encapsulant film, and stacking the cell sheets in a head-to-tail configuration to form one or more cell strings, wherein during the stacking, a back surface of a head end of a cell sheet of the cell sheets is stacked on tail ends of the plurality of front metal wires of a previous adjacent cell sheet of the cell sheets, the plurality of front metal wires are provided on a front surface of each of the cell sheets and respectively cover seed layer fingers and are arranged in parallel, the plurality of front metal wires extend in a head-to-tail direction of a respective cell sheet of the cell sheets, tail ends of the plurality of front metal wires extend to an outer side of a tail end of the respective cell sheet, a sheet conductive connection material for a shingle interconnection is provided in advance on the tail ends of the plurality of front metal wires of each of the cell sheets and/or on a back surface of a head end of each of the cell sheets, and the sheet conductive connection material is an electrically conductive adhesive tape, an ultra-thin alloy material, or an ultra-thin metal sheet coated with a solder material on a surface thereof; and soldering the sheet conductive connection material, so that two adjacent cell sheets in a cell string of the one or more cell strings are fixedly connected together through the sheet conductive connection material;
3) soldering a bus wire and electrode lead wires;
4) laying a back encapsulant film and a photovoltaic backsheet to form a stack to be laminated;
5) laminating the stack in a laminating machine to bond the stack into a unity; and
6) installing a junction box and a module frame.

15. A method for manufacturing a photovoltaic shingled module, **characterized by** comprising the following steps:
1) laying a photovoltaic frontsheet and a front encapsulant film;
2) laying cell sheets each having a plurality of front metal wires on the front encapsulant film, and stacking the cell sheets in a head-to-tail configuration to form one or more cell strings, wherein during the stacking, a back surface of a head end of a cell sheet of the cell sheets is stacked on tail ends of the plurality of front metal wires of a previous adjacent cell sheet of the cell sheets, the plurality of front metal wires are provided on a front surface of each of the cell sheets and respectively cover seed layer fingers and are arranged in parallel, the plurality of front metal wires extend in a head-to-tail direction of a respective cell sheet of the cell sheets, tail ends of the plurality of front metal wires extend to an outer side of a tail end of the respective cell sheet, a sheet conductive connection material for a shingle interconnection is provided in advance on the tail ends of the plurality of front metal wires of each of the cell sheets and/or on a back surface of a head end of each of the cell sheets, and the sheet conductive connection material is an ultra-thin alloy material or an ultra-thin metal sheet coated with a solder material on a surface thereof;
3) soldering a bus wire and electrode lead wires;
4) laying a back encapsulant film and a photovoltaic backsheet to form a stack to be laminated;
5) laminating the stack in a laminating machine to bond the stack into a unity, wherein during the laminating, the ultra-thin alloy material or the solder material on the surface of the ultra-thin metal sheet is melted to fixedly connect two adjacent cell sheets of the cell sheets together; and
6) installing a junction box and a module frame.
